# EUROPÄISCHE PATENTSCHRIFT

(11) **EP 3 045 990 B1**
(45) Veröffentlichungstag und Bekanntmachung des Hinweises auf die Patenterteilung: **05.10.2022**
(21) Anmeldenummer: 15151483.3
(22) Anmeldetag: 16.01.2015
(51) Int. Cl.: G05B 19/409, G06F 3/00

(54) **Remote-Anzeige von Daten mit situationabhängiger Darstellungsänderung**
Remote display of data with situation-dependent display change
Affichage à distance de données avec modification de présentation en fonction de la situation

(43) Veröffentlichungstag der Anmeldung: 20.07.2016
(73) Patentinhaber: Siemens Aktiengesellschaft, 80333 München (DE)
(72) Erfinder: Scheuermann, Uwe, 90431 Nürnberg (DE)

(56) Entgegenhaltungen:
- DE-A1-102012 019 347
- US-A1- 2006 184 532
- US-A1- 2010 042 377
- US-A1- 2011 126 142
- DEJAN KOVACHEV ET AL: "Adaptive Computation Offloading from Mobile Devices into the Cloud", PARALLEL AND DISTRIBUTED PROCESSING WITH APPLICATIONS (ISPA), 2012 IEEE 10TH INTERNATIONAL SYMPOSIUM ON, IEEE, 10 July 2012 (2012-07-10), pages 784-791, XP032224114, DOI: 10.1109/ISPA.2012.115 ISBN: 978-1-4673-1631-6

## Beschreibung

Die vorliegende Erfindung geht aus von einem Betriebsverfahren für eine Anzeigeeinheit einer Werkzeugmaschine,
- wobei die Anzeigeeinheit von einer numerischen Steuerung erste Daten und zweite Daten entgegennimmt,
- wobei die Anzeigeeinheit die ersten und die zweiten Daten über eine Ausgabeeinrichtung der Anzeigeeinheit als Bild an einen Benutzer der Anzeigeeinheit ausgibt,
- wobei die Anzeigeeinheit vom Benutzer einen Darstellungsbefehl entgegennimmt, der eine Veränderung der über die Ausgabeeinrichtung an den Benutzer ausgegebenen ersten und zweiten Daten bewirkt.

Die vorliegende Erfindung geht weiterhin aus von einem Computerprogramm, das Maschinencode umfasst, der von einer eine Ausgabeeinrichtung umfassenden Anzeigeeinheit abarbeitbar ist, wobei die Abarbeitung des Maschinencodes durch die Anzeigeeinheit bewirkt, dass die Anzeigeeinheit ein derartiges Betriebsverfahren ausführt.

Die vorliegende Erfindung geht weiterhin aus von einer Anzeigeeinheit,
- wobei die Anzeigeeinheit eine Ausgabeeinrichtung aufweist und
- wobei die Anzeigeeinheit mit einem derartigen Computerprogramm programmiert ist.

Aus der DE 10 2012 019 347 A1 ist ein Verfahren zum Bedienen eines elektro-mechanischen Antriebssystems bekannt. Dieses Antriebssystem weist einen elektrischen Antrieb, welcher einen Elektromotor und ein Antriebsregelgerät aufweist, eine davon angetriebene Mechanikbaugruppe und ein Touchscreenhandgerät auf. Benutzereingaben zum Bedienen des elektro-mechanischen Antriebssystems erfolgen über den Touchscreen des Touchscreenhandgerätes.

US 2011/126142 A1 beschreibt ein Verfahren zum dynamischen Anzeigen von Daten, die mit einem Prozessregelungssystem verknüpft sind. Das Verfahren umfasst das Empfangen in einer Grafik-Engine von Prozessregelungsinformationen, die von einem Benutzer ausgewählt werden, das Identifizieren von Prozessdaten, die mit den ausgewählten Prozessregelungsinformationen verknüpft sind, und das Abrufen der identifizierten Prozessdaten aus einem Prozessregler. Dazu werden Metadaten verwendet, um eine geeignete Datendarstellungsart zu bestimmen, indem sie die Metadaten mit Querverweisen auf eine entsprechende Datendarstellungsart, die in einer Datenbank mit Metadatenregeln vorgegeben ist, versehen. Die beispielhaften Verfahren und Geräte erstellen eine Instanz einer bestimmten Datendarstellungsart und verknüpfen die Prozessdaten mit der neu erstellten Datendarstellungsinstanz.

Die US 2006/184532 A1 betrifft eine Vorrichtung und ein Verfahren zum effizienten Anzeigen von Bildinhalten, die zwischen einem Server und einem Client gesendet und empfangen werden, in der richtigen Richtung. Ein Bildinhalt, der einen Server bereitstellt, speichert als Eigenschaftsinformationen ursprüngliche Winkelinformationen, die korrekte Richtungen des Bildinhalts als Metadaten des Bildinhalts angeben. Der Server generiert Inhaltsinformationen einschließlich der ursprünglichen Winkelinformationen und sendet die generierten Inhaltsinformationen an einen Client. Dies ermöglicht es dem Client, die korrekte Richtung des vom Server empfangenen Bildinhalts zu verstehen und Bilddaten in der richtigen Richtung zu erhalten und anzuzeigen, indem er eine Rotationsverarbeitung auf dem Clientgerät basierend auf den erhaltenen Informationen durchführt oder den Server auffordert, die auszuführen Rotationsverarbeitung.

US 2010/0042377 A1 beschreibt ein CAD-System mit einem Server zum Bereitstellen von Daten eines CAD-Modells für mindestens einen Client, wobei der Server in der Lage ist, dem Client Abschnittsinformationen bereitzustellen, die eine Vielzahl von geometrischen Abschnitten des CAD-Modells definieren, wobei die Abschnittsinformationen eine Vielzahl von Grenzen umfassen, die jeweils die Vielzahl von geometrischen Abschnitten definieren. Der Client kann auch als Tablet Computer mit einem Display ausgebildet sein und mit dem Server kommunizieren, um beispielsweise einen Ausschnitt des CAD-Modells in einem Ansichtsfenster auf dem Display anzuzeigen.

Aus der Veröffentlichung DEJAN KOVACHEV ET AL: "Adaptive Computation Offloading from Mobile Devices into the Cloud", PARALLEL AND DISTRIBUTED PROCESSING WITH APPLICATIONS (ISPA), 2012 IEEE 10TH INTERNATIONAL SYMPOSIUM ON, IEEE, 10. Juli 2012, Seiten 784-791, XP032224114, DOI: 10.1109/ISPA. 2012.115, ISBN: 978-1-4673-1631-6, geht eine Mobile Augmentation Cloud Services (MACS)-Middleware hervor, die eine adaptive Erweiterung der Android Anwendungsausführung von einem mobilen Client in die Cloud ermöglicht. Die Middleware übernimmt die Hauptarbeit der adaptiven Partitionierung der Anwendung, Ressourcenüberwachung und der Auslagerung von Berechnungen. Abhängig von den Ressourcen des mobilen Clients werden Funktionen auf dem mobilen Client oder in der Cloud ausgeführt.

Bedientafeln für Werkzeugmaschinen sind oftmals nicht direkt an die CNC-Steuerung angeschlossen, sondern erhalten ein anzuzeigendes Bedienbild über ein Protokoll, das beispielsweise über eine Ethernet-Verbindung übertragen wird. Bezogen auf das angezeigte Bedienbild sind verschiedene Funktionen möglich. Beispielsweise können Bildausschnitte geändert oder verschoben werden, verschiedene Fenster einander überlagert werden und dergleichen mehr. Auch ist es möglich, bezüglich angezeigter Elemente Skalierungen vorzunehmen, beispielsweise angezeigte Elemente zu vergrößern oder zu verkleinern. Eine CNC-Steuerung ist eine Recheneinheit im Sinne der vorliegenden Erfindung. Die Recheneinheit kann jedoch auch anders ausgebildet sein, beispielsweise als CAD-System oder als CAM-System.

Als Bedientafel können auch intelligente mobile Geräte wie beispielsweise Notebooks oder Tablet-PCs verwendet werden. Auch bei Verwendung derartiger Geräte als Bedientafel sind die genannten Funktionen möglich. Insbesondere derartige intelligente Geräte sind Anzeigeeinheiten im Sinne der vorliegenden Erfindung.

Bezüglich der angezeigten Daten gibt es verschiedene Arten von Daten. Zum einen kann es sich um alphanumerische Daten wie beispielsweise Drehzahlen, Anstellungen, Beschreibungen, Positionierungen und dergleichen mehr handeln. Zum anderen kann es sich um grafische Bilddaten handeln.

Falls als Anzeigeeinheit nicht eine intelligente Anzeigeeinheit verwendet wird, müssen alle auf das angezeigte Bedienbild bezogenen Funktionen von der Recheneinheit ausgeführt werden. Die Anzeigeeinheit nimmt also zwar den die entsprechende Funktion spezifizierenden Befehl (= Darstellungsbefehl) entgegen, übermittelt ihn aber stets und ausnahmslos an die Recheneinheit. Von der Recheneinheit nimmt die Anzeigeeinheit entsprechend dem Befehl veränderte erste und/oder zweite Daten entgegen und gibt die entsprechenden ersten und/oder zweiten Daten über den Bildschirm an den Benutzer aus.

Falls als Anzeigeeinheit eine intelligente Anzeigeeinheit verwendet wird, können auf das angezeigte Bedienbild bezogene Funktionen alternativ von der Recheneinheit oder von dem Prozessor der intelligenten Anzeigeeinheit ausgeführt werden. Eine Ausführung durch die intelligente Anzeigeeinheit weist den Vorteil auf, dass weder eine Kommunikation mit der Recheneinheit erforderlich ist noch eine Ermittlung der geänderten Daten durch die Recheneinheit erforderlich ist. Die Recheneinheit wird dadurch entlastet. Weiterhin kann die Ermittlung der geänderten Daten in vielen Fällen beschleunigt werden.

Die Ermittlung der geänderten Daten durch die Anzeigeeinheit kann jedoch keine zusätzliche Information generieren. Wenn beispielsweise ein über den Bildschirm dargestelltes Objekt vergrößert wird, werden für ein Bildelement, das zuvor als einzelnes Pixel dargestellt wurde, nunmehr stattdessen beispielsweise 2 x 2 = 4 oder 3 x 3 = 9 Pixel verwendet. Die Bildinformation als solche ist jedoch unverändert geblieben. Insbesondere graphische Daten werden von der Recheneinheit jedoch oftmals aufgrund von geometrischen Daten ermittelt, die bei entsprechender Vergrößerung eine erheblich genauere Darstellung zulassen. Wenn daher insbesondere ein Darstellungsbefehl an die Recheneinheit übermittelt wird, kann dem Benutzer durch die Recheneinheit ein zusätzlicher Informationsgehalt zur Verfügung gestellt werden.

Ähnliche Probleme stellen sich, wenn andere Darstellungsbefehl vorgegeben werden. Bei einem Verkleinern müssen beispielsweise zusätzliche Elemente, die zuvor außerhalb des sichtbaren Bildbereichs angeordnet waren, dargestellt werden. Bei einem Rotieren werden manche Bildelemente, die zuvor verdeckt waren sichtbar. Ebenso werden manche Bildelemente, die zuvor sichtbar waren, nunmehr verdeckt. Gleiches gilt für einen Schiebebefehl zum Verschieben eines dargestellten Bildausschnittes, d.h. einen Befehl, bei dem ein dargestellter Bildausschnitt ohne Änderung der Skalierung und ohne Rotation nach links oder rechts, nach oben oder unten verschoben wird. Es ist möglich, dass der Benutzer zusammen mit einem Darstellungsbefehl auch vorgibt, ob dieser Darstellungsbefehl lokal von der Anzeigeeinheit ausgeführt werden soll oder ob dieser Darstellungsbefehl an die Recheneinheit übermittelt und von der Recheneinheit ausgeführt werden soll. Diese Vorgehensweise ist zum einen umständlich und fehlerträchtig. Darüber hinaus muss der Benutzer wissen, welche Daten sinnvollerweise von der Anzeigeeinheit verändert werden können und welche Daten sinnvollerweise von der Recheneinheit verändert werden sollten.

Die Aufgabe der vorliegenden Erfindung besteht darin, Möglichkeiten zu schaffen, mittels derer in einfacher, automatisierter Weise die Recheneinheit von der Ausführung von Darstellungsbefehlen so weit wie möglich entlastet wird und dennoch dem Benutzer stets eine optimale Bildinformation zur Verfügung gestellt wird.

Die Aufgabe wird durch ein Betriebsverfahren mit den Merkmalen des Anspruchs 1 gelöst. Vorteilhafte Ausgestaltungen des Betriebsverfahrens sind Gegenstand der abhängigen Ansprüche 2 und 3.

Erfindungsgemäß wird ein Betriebsverfahren dadurch ausgestaltet,
- dass die Anzeigeeinheit von der numerischen Steuerung zusätzlich zu den ersten Daten und den zweiten Daten den ersten Daten zugeordnete erste Metadaten und den zweiten Daten zugeordnete zweite Metadaten entgegennimmt,
- wobei die Anzeigeeinheit in dem Fall, dass der Darstellungsbefehl auf die ersten Daten bezogen ist, in Abhängigkeit von den den ersten Daten zugeordneten ersten Metadaten entscheidet, ob sie die angezeigten ersten Daten zur Entlastung der numerischen Steuerung (1) ohne Zwischenschaltung der numerischen Steuerung entsprechend des Darstellungsbefehls verändert und die entsprechend veränderten ersten Daten über die Ausgabeeinrichtung an den Benutzer ausgibt oder ob sie den Darstellungsbefehl an die Recheneinheit übermittelt, von der numerischen Steuerung entsprechend dem Darstellungsbefehl veränderte erste Daten und den ersten Daten zugeordnete erste Metadaten entgegennimmt und die entsprechend veränderten ersten Daten über die Ausgabeeinrichtung an den Benutzer ausgibt, und
- wobei die Anzeigeeinheit in dem Fall, dass der Darstellungsbefehl auf die zweiten Daten bezogen ist, in Abhängigkeit von den den zweiten Daten zugeordneten zweiten Metadaten entscheidet, ob sie die angezeigten zweiten Daten zur Entlastung der numerischen Steuerung (1) ohne Zwischenschaltung der numerischen Steuerung entsprechend des Darstellungsbefehls verändert und die entsprechend veränderten zweiten Daten über die Ausgabeeinrichtung an den Benutzer ausgibt oder ob sie den Darstellungsbefehl an die numerische Steuerung übermittelt, von der numerischen Steuerung entsprechend dem Darstellungsbefehl veränderte zweite Daten und den zweiten Daten zugeordnete zweite Metadaten entgegennimmt und die entsprechend veränderten zweiten Daten über die Ausgabeeinrichtung an den Benutzer ausgibt.

Vorzugsweise wird der Darstellungsbefehl der Anzeigeeinheit durch eine auf das ausgegebene Bild bezogene, vom Benutzer applizierte Fingergeste vorgegeben. Wenn beispielsweise die Ausgabeeinrichtung als Touchscreen ausgebildet ist, wie dies beispielsweise bei Tablet-PCs typischerweise der Fall ist, kann die Fingergeste vom Benutzer auf dem Touchscreen appliziert werden.

Es ist möglich, dass der Darstellungsbefehl ein Zoombefehl zum Vergrößern oder zum Verkleinern der dargestellten ersten oder zweiten Daten ist. Alternativ ist es möglich, dass der Darstellungsbefehl ein Rotationsbefehl zum Rotieren einer dreidimensionalen Darstellung oder ein Schiebebefehl zum Verschieben eines dargestellten Bildausschnittes ist.

Die Aufgabe wird weiterhin durch ein Computerprogramm mit den Merkmalen des Anspruchs 4 gelöst. Eine vorteilhafte Ausgestaltung des Computerprogramms ist Gegenstand des abhängigen Anspruchs 5.

Erfindungsgemäß bewirkt die Abarbeitung des Maschinencodes durch die Anzeigeeinheit, dass die Anzeigeeinheit ein erfindungsgemäßes Betriebsverfahren ausführt.

Das Computerprogramm kann insbesondere in einem Speicher in maschinenlesbarer Form beispielsweise in elektronischer Form hinterlegt sein.

Die Aufgabe wird weiterhin durch eine Anzeigeeinheit mit den Merkmalen des Anspruchs 6 gelöst. Eine vorteilhafte Ausgestaltung der Anzeigeeinheit ist Gegenstand des abhängigen Anspruchs 7.

Erfindungsgemäß ist die Anzeigeeinheit mit einem erfindungsgemäßen Computerprogramm programmiert.

Die Anzeigeeinheit kann insbesondere als Tablet-PC, als Notebook oder als Smartphone ausgebildet sein.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: ein Blockdiagramm,
- FIG 2: ein Ablaufdiagramm und
- FIG 3: eine mögliche Anzeige.

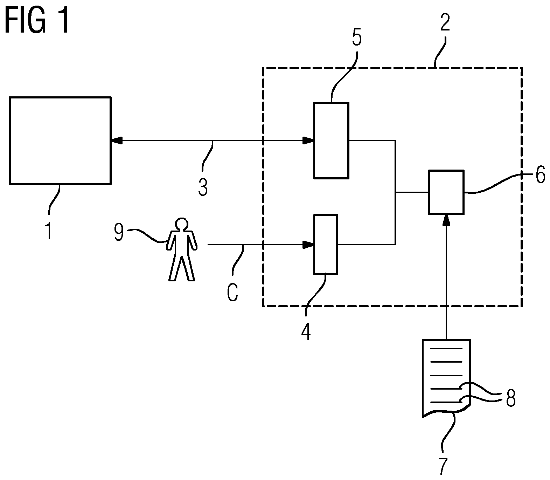

Gemäß FIG 1 kommuniziert eine Recheneinheit 1 mit einer Anzeigeeinheit 2. Die Recheneinheit 1 ist zu diesem Zweck mit der Anzeigeeinheit 2 über eine Datenverbindung 3 verbunden.

Die Recheneinheit 1 ist eine numerische Steuerung. Die Anzeigeeinheit 2 ist eine intelligente Anzeigeeinheit. Sie umfasst zusätzlich zu einer Ausgabeeinrichtung 4 zumindest einen Prozessor 5 und einen Speicher 6. Die Anzeigeeinheit 2 kann beispielsweise als Tablet-PC, als Notebook oder als Smartphone ausgebildet sein. Die Datenverbindung 3 kann beispielsweise auf Ethernet-Physik basieren. Die Ausgabeeinrichtung 4 kann beispielsweise als Bildschirm ausgebildet sein, insbesondere als Touchscreen.

Im Speicher 6 ist in maschinenlesbarer Form beispielsweise in elektronischer Form ein Computerprogramm 7 hinterlegt. Das Computerprogramm 7 umfasst Maschinencode 8, der von der Anzeigeeinheit 2 abarbeitbar ist. Die Anzeigeeinheit 2 ist mit dem Computerprogramm 7 programmiert. Die Abarbeitung des Maschinencodes 8 durch die Anzeigeeinheit 2 bewirkt, dass die Anzeigeeinheit 2 ein Betriebsverfahren ausführt, das nachfolgend in Verbindung mit den weiteren FIG näher erläutert wird.

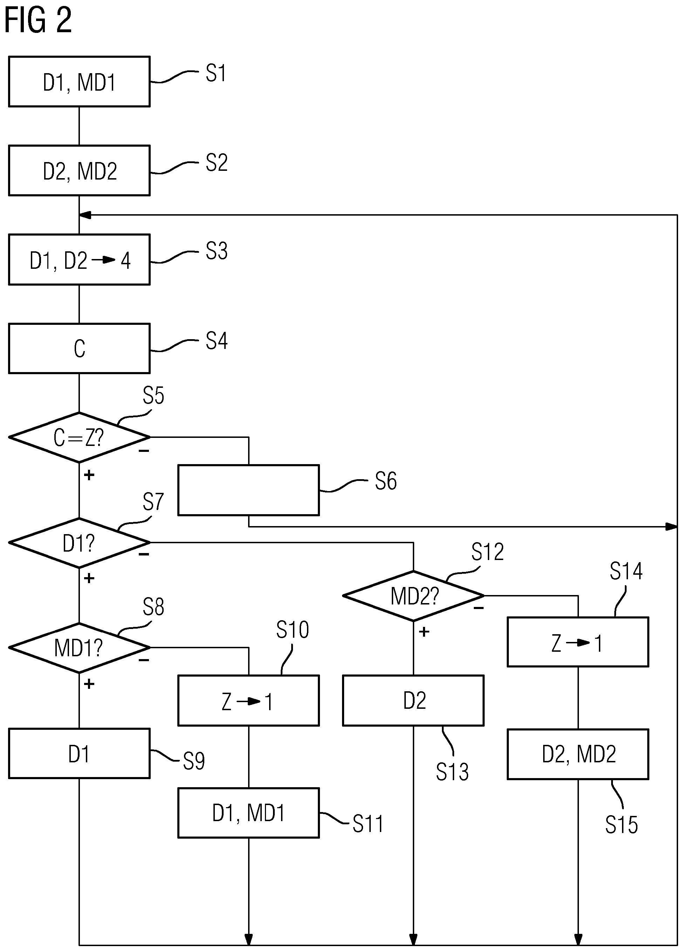

Gemäß FIG 2 nimmt die Anzeigeeinheit 2 in einem Schritt S1 erste Daten D1 entgegen. Die Anzeigeeinheit 2 nimmt im Schritt S1 weiterhin erste Metadaten MD1 entgegen. Die ersten Metadaten MD1 sind den ersten Daten D1 zugeordnet. In einem Schritt S2 nimmt die Anzeigeeinheit 2 weiterhin zweite Daten D2 entgegen. Die Anzeigeeinheit 2 nimmt im Schritt S2 weiterhin zweite Metadaten MD2 entgegen. Die zweiten Metadaten MD2 sind den zweiten Daten D2 zugeordnet. Das Entgegennehmen der ersten Daten D1, der ersten Metadaten MD1, der zweiten Daten D2 und der zweiten Metadaten MD2 kann auch in einem einzigen Schritt zusammengefasst sein. Unabhängig davon, ob die eine oder die andere Vorgehensweise ergriffen wird, werden die jeweiligen Daten D1, D2 jedoch, bezogen auf die Darstellung, in der Regel von oben nach unten übertragen.

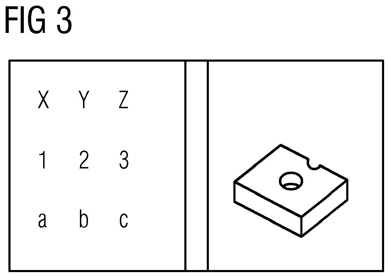

In einem Schritt S3 gibt die Anzeigeeinheit 2 die ersten und die zweiten Daten D1, D2 über die Ausgabeeinrichtung 4 als Bild 4 an einen Benutzer 9 aus. FIG 3 zeigt rein beispielhaft eine Anzeige, wie sie über die Ausgabeeinrichtung 4 an den Benutzer 9 ausgegeben wird. Gemäß FIG 3 werden im linken Teil der Ausgabeeinrichtung 4 die ersten Daten D1 an den Benutzer 9 ausgegeben. Bei den Daten D1 kann es sich (beispielsweise) um alphanumerische Daten handeln. Im rechten Teil der Ausgabeeinrichtung 4 werden die zweiten Daten D2 an den Benutzer 9 ausgegeben. Bei den Daten D2 kann es sich (beispielsweise) um graphische Daten handeln, beispielsweise um eine Darstellung eines Werkstücks.

In einem Schritt S4 nimmt die Anzeigeeinheit 2 vom Benutzer 9 einen Befehl C entgegen. In einem Schritt S5 prüft die Anzeigeeinheit 2, ob es sich bei dem Befehl C um einen Darstellungsbefehl Z handelt. Wenn dies nicht der Fall ist, geht die Anzeigeeinheit 2 zu einem Schritt S6 über, in dem sie eine Aktion ausführt. Die Aktion ist selbstverständlich von dem Befehl C abhängig. Sodann geht die Anzeigeeinheit 2 zum Schritt S3 zurück.

Wenn es sich bei dem Befehl C um einen Darstellungsbefehl Z handelt, prüft die Anzeigeeinheit 2 in einem Schritt S7, ob der Darstellungsbefehl Z auf die ersten Daten D1 bezogen ist.

Wenn der Darstellungsbefehl Z auf die ersten Daten D1 bezogen ist, geht die Anzeigeeinheit 2 zu einem Schritt S8 über. Im Schritt S8 entscheidet die Anzeigeeinheit 2 in Abhängigkeit von den ersten Metadaten MD1, ob sie die angezeigten ersten Daten D1 direkt verarbeiten soll oder nicht.

Wenn sie die ersten Daten D1 direkt verarbeiten soll, geht die Anzeigeeinheit 2 zu einem Schritt S9 über. Im Schritt S9 verändert die Anzeigeeinheit 2 die ersten Daten D1. Den Schritt S9 führt die Anzeigeeinheit 2 ohne Zwischenschaltung der Recheneinheit 1 aus. Sodann geht die Anzeigeeinheit 2 zum Schritt S3 zurück. Bei der erneuten Ausführung des Schrittes S3 gibt die Anzeigeeinheit 2 die entsprechend veränderten ersten Daten D1 über die Ausgabeeinrichtung 4 an den Benutzer 9 aus.

Wenn die Anzeigeeinheit 2 hingegen die ersten Daten D1 nicht direkt verarbeiten soll, geht die Anzeigeeinheit 2 zu einem Schritt S10 über. Im Schritt S10 übermittelt die Anzeigeeinheit 2 den Darstellungsbefehl Z an die Recheneinheit 1. Die Recheneinheit 1 ermittelt aufgrund des übermittelten Darstellungsbefehls Z veränderte erste Daten D1. Die entsprechend veränderten ersten Daten D1 nimmt die Anzeigeeinheit 2 in einem Schritt S11 von der Recheneinheit 1 entgegen. Im Schritt S11 nimmt die Anzeigeeinheit 2 weiterhin analog zum Schritt S1 von der Recheneinheit 1 die zugehörigen ersten Metadaten MD1 entgegen. Sodann geht die Anzeigeeinheit 2 zum Schritt S3 zurück.

Wenn der Darstellungsbefehl Z auf die zweiten Daten D2 bezogen ist, geht die Anzeigeeinheit 2 zu einem Schritt S12 über. Im Schritt S12 entscheidet die Anzeigeeinheit 2 in Abhängigkeit von den zweiten Metadaten MD2, ob sie die angezeigten zweiten Daten D2 direkt verarbeiten soll oder nicht.

Wenn sie die zweiten Daten D2 direkt verarbeiten soll, geht die Anzeigeeinheit 2 zu einem Schritt S13 über. Im Schritt S13 verändert die Anzeigeeinheit 2 die zweiten Daten D2. Den Schritt S13 führt die Anzeigeeinheit 2 ohne Zwischenschaltung der Recheneinheit 1 aus. Sodann geht die Anzeigeeinheit 2 zum Schritt S3 zurück. Bei der erneuten Ausführung des Schrittes S3 gibt die Anzeigeeinheit 2 die entsprechend veränderten zweiten Daten D2 über die Ausgabeeinrichtung 4 an den Benutzer 9 aus.

Wenn die Anzeigeeinheit 2 hingegen die zweiten Daten D2 nicht direkt verarbeiten soll, geht die Anzeigeeinheit 2 zu einem Schritt S14 über. Im Schritt S14 übermittelt die Anzeigeeinheit 2 den Darstellungsbefehl Z an die Recheneinheit 1. Die Recheneinheit 1 ermittelt aufgrund des übermittelten Darstellungsbefehls Z veränderte zweite Daten D2. Die entsprechend veränderten zweiten Daten D2 nimmt die Anzeigeeinheit 2 in einem Schritt S15 von der Recheneinheit 1 entgegen. Im Schritt S15 nimmt die Anzeigeeinheit 2 weiterhin analog zum Schritt S2 von der Recheneinheit 1 die zugehörigen zweiten Metadaten MD2 entgegen. Sodann geht die Anzeigeeinheit 2 zum Schritt S3 zurück.

Der Darstellungsbefehl Z kann beispielsweise ein Zoombefehl ein Befehl zum Vergrößern oder zum Verkleinern der dargestellten ersten oder zweiten Daten D1, D2 sein. Es ist jedoch alternativ möglich, dass der Darstellungsbefehl Z ein Rotationsbefehl zum Rotieren einer dreidimensionalen Darstellung ist. Auch ist es möglich, dass der Darstellungsbefehl Z ein Schiebebefehl zum Verschieben eines dargestellten Bildausschnittes ist.

Befehle C können zumindest in manchen Fällen der Anzeigeeinheit 2 durch auf das ausgegebene Bild bezogene, vom Benutzer 9 applizierte Fingergesten vorgegeben werden. Dies gilt auch für Darstellungsbefehle Z. Beispielsweise kann die Ausgabeeinrichtung 4 entsprechend der Darstellung in FIG 1 als Touchscreen ausgebildet sein. In diesem Fall können Befehle C durch entsprechende, auf dem Bildschirm 4 applizierte Fingergesten vorgegeben werden. Dies ist in FIG 1 durch eine Vorgabe von Befehlen C über den Bildschirm 4 angedeutet. Zusammengefasst betrifft die vorliegende Erfindung somit folgenden Sachverhalt:
Eine Anzeigeeinheit 2 nimmt von einer numerischen Steuerung 1 erste Daten D1 und zweite Daten D2 entgegen. Sie nimmt weiterhin von der numerischen Steuerung 1 zusätzlich zu den ersten Daten D1 und den zweiten Daten D2 den ersten Daten D1 zugeordnete erste Metadaten MD1 und den zweiten Daten D2 zugeordnete zweite Metadaten MD2 entgegen. Die Anzeigeeinheit 2 gibt die ersten und die zweiten Daten D1, D2 über eine Anzeigeeinrichtung 4 als Bild an einen Benutzer 9 aus. Sie nimmt vom Benutzer 9 einen Darstellungsbefehl Z entgegen. Die Anzeigeeinheit 2 entscheidet in Abhängigkeit von den Metadaten MD1, MD2, die denjenigen Daten D1, D2 zugeordnet sind, auf welche der Darstellungsbefehl Z bezogen ist, ob sie die entsprechenden Daten D1, D2 zur Entlastung der numerischen Steuerung ohne Zwischenschaltung der numerischen Steuerung 1 entsprechend des Darstellungsbefehls Z verändert und die entsprechend veränderten Daten D1, D2 über die Ausgabeeinrichtung 4 an den Benutzer 9 ausgibt oder ob sie den Darstellungsbefehl Z an die numerische Steuerung 1 übermittelt, von der numerischen Steuerung 1 entsprechend dem Darstellungsbefehl Z veränderte entsprechende Daten D1, D2 und den entsprechenden Daten D1, D2 zugeordnete Metadaten MD1, MD2 entgegennimmt und die entsprechend veränderten Daten D1, D2 über die Ausgabeeinrichtung 4 an den Benutzer 9 ausgibt.

Die vorliegende Erfindung ermöglicht dem Benutzer 9 auf einfache und zuverlässige Weise eine effiziente Bedienung der Anzeigeeinheit 2. Dabei werden insbesondere grafische Darstellungen stets entsprechend der möglichen Auflösungsgenauigkeit über die Ausgabeeinrichtung 4 an den Benutzer 9 ausgegeben.

## Patentansprüche

1. Betriebsverfahren für eine Anzeigeeinheit (2) einer Werkzeugmaschine,
- wobei die Anzeigeeinheit (2) von einer numerischen Steuerung erste Daten (D1) und zweite Daten (D2) entgegennimmt,
- wobei die Anzeigeeinheit (2) die ersten und die zweiten Daten (D1, D2) über eine Ausgabeeinrichtung (4) der Anzeigeeinheit (2) als Bild an einen Benutzer (9) der Anzeigeeinheit (2) ausgibt,
- wobei die Anzeigeeinheit (2) vom Benutzer (9) einen Darstellungsbefehl (Z) entgegennimmt, der eine Veränderung der über die Ausgabeeinrichtung (4) an den Benutzer (9) ausgegebenen ersten und zweiten Daten (D1, D2) bewirkt,
- wobei die Anzeigeeinheit (2) von der numerischen Steuerung (1) zusätzlich zu den ersten Daten (D1) und den zweiten Daten (D2) den ersten Daten (D1) zugeordnete erste Metadaten (MD1) und den zweiten Daten (D2) zugeordnete zweite Metadaten (MD2) entgegennimmt,
- wobei die Anzeigeeinheit (2) prüft, ob der Darstellungsbefehl (Z) auf die ersten Daten (D1) oder die zweiten Daten (D2) bezogen ist,
- wobei die Anzeigeeinheit (2) in dem Fall, dass der Darstellungsbefehl (Z) auf die ersten Daten (D1) bezogen ist, in Abhängigkeit von den den ersten Daten (D1) zugeordneten ersten Metadaten (MD1) entscheidet, ob sie die angezeigten ersten Daten (D1) zur Entlastung der numerischen Steuerung (1) ohne Zwischenschaltung der numerischen Steuerung (1) entsprechend des Darstellungsbefehls (Z) verändert und die entsprechend veränderten ersten Daten (D1) über die Ausgabeeinrichtung (4) an den Benutzer (9) ausgibt oder ob sie den Darstellungsbefehl (Z) an die numerische Steuerung (1) übermittelt, von der numerischen Steuerung (1) entsprechend dem Darstellungsbefehl (Z) veränderte erste Daten (D1) und den ersten Daten (D1) zugeordnete erste Metadaten (MD1) entgegennimmt und die entsprechend veränderten ersten Daten (D1) über die Ausgabeeinrichtung (4) an den Benutzer (9) ausgibt, und
- wobei die Anzeigeeinheit (2) in dem Fall, dass der Darstellungsbefehl (Z) auf die zweiten Daten (D2) bezogen ist, in Abhängigkeit von den den zweiten Daten (D2) zugeordneten zweiten Metadaten (MD2) entscheidet, ob sie die angezeigten zweiten Daten (D2) zur Entlastung der numerischen Steuerung (1) ohne Zwischenschaltung der numerischen Steuerung (1) entsprechend des Darstellungsbefehls (Z) verändert und die entsprechend veränderten zweiten Daten (D2) über die Ausgabeeinrichtung (4) an den Benutzer (9) ausgibt oder ob sie den Darstellungsbefehl (Z) an die numerische Steuerung (1) übermittelt, von der numerischen Steuerung (1) entsprechend dem Darstellungsbefehl (Z) veränderte zweite Daten (D2) und den zweiten Daten (D2) zugeordnete zweite Metadaten (MD2) entgegennimmt und die entsprechend veränderten zweiten Daten (D2) über die Ausgabeeinrichtung (4) an den Benutzer (9) ausgibt.

2. Betriebsverfahren nach Anspruch 1, wobei der Darstellungsbefehl (Z) der Anzeigeeinheit (2) durch eine auf das ausgegebene Bild bezogene, vom Benutzer (9) applizierte Fingergeste vorgegeben wird.

3. Betriebsverfahren nach Anspruch 1 oder 2, wobei der Darstellungsbefehl (Z) ein Zoombefehl zum Vergrößern oder zum Verkleinern der dargestellten ersten oder zweiten Daten (D1, D2), ein Rotationsbefehl zum Rotieren einer dreidimensionalen Darstellung oder ein Schiebebefehl zum Verschieben eines dargestellten Bildausschnittes ist.

4. Computerprogramm, das Maschinencode (8) umfasst, der von einer eine Ausgabeeinrichtung (4) umfassenden Anzeigeeinheit (2) abarbeitbar ist, wobei die Abarbeitung des Maschinencodes (8) durch die Anzeigeeinheit (2) bewirkt, dass die Anzeigeeinheit (2) ein Betriebsverfahren nach einem der obigen Ansprüche ausführt.

5. Computerprogramm nach Anspruch 4, wobei das Computerprogramm in einem Speicher (6) in maschinenlesbarer Form hinterlegt ist.

6. Anzeigeeinheit,
- wobei die Anzeigeeinheit eine Ausgabeeinrichtung (4) aufweist und
- wobei die Anzeigeeinheit mit einem Computerprogramm (7) nach Anspruch 4 programmiert ist.

7. Anzeigeeinheit nach Anspruch 6, wobei die Anzeigeeinheit (2) als Tablet-PC, als Notebook oder als Smartphone ausgebildet ist.

## Claims

1. Method for operating a display unit (2) of a machine tool,
- wherein the display unit (2) receives first data (D1) and second data (D2) from a numeric controller,
- wherein the display unit (2) outputs the first data and the second data (D1, D2) by way of an output device (4) of the display unit (2) as an image to a user (9) of the display unit (2),
- wherein the display unit (2) receives a representation command (Z) from the user (9) which effects a modification of the first and second data (D1, D2) output by way of the output device (4) to the user (9),
- wherein the display unit (2) receives from the numeric controller (1) first metadata (MD1) associated with the first data (D1) and second metadata (MD2) associated with the second data (D2) in addition to the first data (D1) and the second data (D2),
- wherein the display unit (2) checks whether the representation command (Z) relates to the first data (D1) or the second data (D2),
- wherein in the case that the representation command (Z) relates to the first data (D1) the display unit (2) decides depending on the first metadata (MD1) associated with the first data (D1) whether it modifies the displayed first data (D1) to reduce the workload of the numeric controller (1) without involving the numeric controller (1) in accordance with the representation command (Z) and outputs the correspondingly modified first data (D1) by way of the output device (4) to the user (9) or whether it conveys the representation command (Z) to the numeric controller (1), receives from the numeric controller (1) first data (D1) modified in accordance with the representation command (Z) and first metadata (MD1) associated with the first data (D1) and outputs the correspondingly modified first data (D1) by way of the output device (4) to the user (9), and
- wherein in the case that the representation command (Z) relates to the second data (D2) the display unit (2) decides depending on the second metadata (MD2) associated with the second data (D2) whether it modifies the displayed second data (D2) to reduce the workload of the numeric controller (1) without involving the numeric controller (1) in accordance with the representation command (Z) and outputs the correspondingly modified second data (D2) by way of the output device (4) to the user (9) or whether it conveys the representation command (Z) to the numeric controller (1), receives from the numeric controller (1) second data (D2) modified in accordance with the representation command (Z) and second metadata (MD2) associated with the second data (D2) and outputs the correspondingly modified second data (D2) by way of the output device (4) to the user (9).

2. Operating method according to claim 1,
wherein the representation command (Z) is given to the display unit (2) by means of a finger gesture relating to the image output, applied by the user (9).

3. Operating method according to claim 1 or 2,
wherein the representation command (Z) is a zoom command for increasing or for reducing the size of the first or second data (D1, D2) represented, a rotation command for rotating a three-dimensional representation or a shift command for shifting a represented image section.

4. Computer program which comprises machine code (8) that can be processed by a display unit (2) comprising an output device (4), wherein the processing of the machine code (8) by the display unit (2) causes the display unit (2) to perform an operating method according to one of the above claims.

5. Computer program according to claim 4,
wherein the computer program is stored in a storage device (6) in machine-readable form.

6. Display unit
- wherein the display unit has an output device (4) and
- wherein the display unit is programmed with a computer program (7) according to claim 4.

7. Display unit according to claim 6,
wherein the display unit (2) is embodied as a tablet PC, as a notebook or as a smartphone.

## Revendications

1. Procédé pour faire fonctionner une unité (2) d'affichage d'une machine-outil,
- dans lequel l'unité (2) d'affichage reçoit des premières données (D1) et des deuxièmes données (D2) d'une commande numérique,
- dans lequel l'unité (2) d'affichage sort, par l'intermédiaire d'un dispositif (4) de sortie de l'unité (2) d'affichage, les premières et les deuxièmes données (D1, D2) comme image pour un utilisateur (9) de l'unité (2) d'affichage,
- dans lequel l'unité (2) d'affichage reçoit de l'utilisateur (9) une instruction (Z) de présentation, qui provoque une modification des premières et deuxièmes données (D1, D2) sorties pour l'utilisateur (9) par l'intermédiaire du dispositif (4) de sortie,
- dans lequel l'unité (2) d'affichage reçoit de la commande (1) numérique, en plus des premières données (D1) et des deuxièmes données (D2), des premières métadonnées (MD1) associées aux premières données (D1) et des deuxièmes métadonnées (MD2) associées aux deuxièmes données (D2),
- dans lequel l'unité (2) d'affichage contrôle si l'instruction (Z) de présentation se rapporte aux premières données (D1) ou aux deuxièmes données (D2),
- dans lequel l'unité (2) d'affichage, dans le cas où l'instruction (Z) de présentation se rapporte aux premières données (D1), décide, en fonction des premières métadonnées (MD1) associées aux premières données (D1), si elle modifie, conformément à l'instruction (Z) de présentation, sans interposition de la commande (1) numérique, les premières données (D1) affichées pour décharger la commande (1) numérique et sort les premières données (D1) modifiées de manière correspondante par le dispositif (4) de sortie pour l'utilisateur (9) ou, si elle transmet l'instruction (Z) de présentation à la commande (1) numérique, reçoit de la commande (1) numérique des premières données (D1) modifiées conformément à l'instruction (Z) de présentation et des premières métadonnées (MD1) associées aux premières données (D1) et sort les premières données (D1) modifiées d'une manière correspondante par le dispositif (4) de sortie pour l'utilisateur (9), et
- dans lequel l'unité (2) d'affichage décide, dans le cas où l'instruction (Z) de présentation se rapporte aux deuxièmes données (D2), en fonction des deuxièmes métadonnées (MD2) associées aux deuxièmes données (D2), si elle modifie, conformément à l'instruction (Z) de présentation sans interposition de la commande (1) numérique, les deuxièmes données (D2) affichées pour décharger la commande (1) numérique et sort les deuxièmes données (D2) modifiées de manière correspondante par l'intermédiaire du dispositif (4) de sortie pour l'utilisateur (9) ou si elle transmet l'instruction (Z) de présentation à la commande (1) numérique, reçoit de la commande (1) numérique des deuxièmes données (D2) modifiées conformément à l'instruction (Z) de présentation et des deuxièmes métadonnées (MD2) associées aux deuxièmes données (D2) et sort les deuxièmes données (D2) modifiées de manière correspondante par l'intermédiaire du dispositif (4) de sortie pour l'utilisateur (9).

2. Procédé suivant la revendication 1,
dans lequel
on prescrit l'instruction (Z) de présentation de l'unité (2) d'affichage par un geste du doigt appliqué par l'utilisateur (9) et rapporté à l'image sortie.

3. Procédé suivant la revendication 1 ou 2,
dans lequel
l'instruction (Z) de présentation est une instruction de zoom pour l'agrandissement ou le rapetissement des premières ou deuxièmes données (D1, D2) présentées, une instruction de rotation pour faire tourner une présentation en trois dimensions ou une instruction de déplacement pour le déplacement d'une partie de l'image présentée.

4. Programme d'ordinateur, qui comprend un code machine (8), qui peut être élaboré par une unité (2) d'affichage comprenant un dispositif (4) de sortie, l'élaboration du code machine (8) par l'unité (2) d'affichage faisant que l'unité (2) d'affichage effectue un procédé suivant l'une des revendications précédentes.

5. Programme d'ordinateur suivant la revendication 4,
dans lequel
le programme d'ordinateur est mis dans une mémoire (6) sous une forme déchiffrable par machine.

6. Unité d'affichage,
- dans laquelle l'unité d'affichage a un dispositif (4) de sortie et
- dans laquelle l'unité d'affichage est programmé par un programme (7) d'ordinateur suivant la revendication 4.

7. Unité d'affichage suivant la revendication 6,
dans laquelle
l'unité (2) d'affichage est constituée sous la forme d'une tablette-PC, d'un notebook ou d'un téléphone intelligent.
